# EUROPÄISCHE PATENTSCHRIFT

(11) **EP 1 192 841 B1**
(45) Veröffentlichungstag und Bekanntmachung des Hinweises auf die Patenterteilung: **09.07.2003**
(21) Anmeldenummer: 00935161.0
(22) Anmeldetag: 31.05.2000
(51) Int. Cl.: H05K 1/14, H05K 1/18, H01L 25/16

(54) **INTELLIGENTES LEISTUNGSMODUL**
INTELLIGENT POWER MODULE
MODULE DE PUISSANCE INTELLIGENT

(30) Priorität: 31.05.1999 DE 19924991; 31.05.1999 DE 19924994
(43) Veröffentlichungstag der Anmeldung: 03.04.2002
(73) Patentinhaber: TYCO Electronics Logistics AG, 9323 Steinach (CH)
(72) Erfinder: FRISCH, Michael, D-91379 München (DE)
(74) Vertreter: Hirsch, Peter, Dipl.-Ing.
(86) Internationale Anmeldenummer: EP0005021
(87) Internationale Veröffentlichungsnummer: WO00074446

(56) Entgegenhaltungen:
- EP-A- 0 708 583
- WO-A-96/13966
- DE-A- 3 813 566
- DE-A- 19 713 656
- US-A- 4 306 275
- US-A- 4 495 546
- US-A- 5 266 746
- US-A- 5 484 965
- US-A- 5 488 256
- PATENT ABSTRACTS OF JAPAN vol. 015, no. 233 (E-1077), 14. Juni 1991 (1991-06-14) & JP 03 069185 A (NEC CORP), 25. März 1991 (1991-03-25)
- PATENT ABSTRACTS OF JAPAN vol. 015, no. 054 (E-1031), 28. Februar 1991 (1991-02-28) & JP 02 281790 A (MATSUSHITA ELECTRIC IND CO), 19. November 1990 (1990-11-19)
- PATENT ABSTRACTS OF JAPAN vol. 014, no. 394 (E-0969), 24. August 1990 (1990-08-24) & JP 02 148759 A (TOSHIBA CORP), 7. Juni 1990 (1990-06-07)

## Beschreibung

Die Erfindung betrifft ein intelligentes Leistungsmodul, insbesondere in Sandwich-Bauweise.

Die US-A-5 488 256 zeigt ein intelligentes Leistungsmodul nach dem Oberbegriff von Anspruch 1.

IPM(Intelligent-Power-Modul) -Bauformen, also Module mit einem Leistungsteil mit elektronischen Bauelementen und einem im Modul integrierten Logik- bzw. Ansteuerungsteil, werden gegenwärtig beispielsweise bei Anwendungen im Zusammenhang mit Schweissgeräten, Stromversorgungen und in der Antriebstechnik eingesetzt. Insbesondere im Bereich der Asynchronmotoren werden zunehmend Frequenzumrichterlösungen zur Drehzahlsteuerung eingesetzt, wobei im Leistungsteil des Moduls insbesondere IGBT(Isolated-Gate-Bipolar-Transistor)-Leistungshalbleiter Verwendung finden.

Bei der Auswahl des Leistungssubstrats als Träger für die Bauelemente des Leistungsteils ist zu beachten, dass zur üblicherweise erforderlichen Kühlplatte hin einerseits eine hohe elektrische Isolation, andererseits aber auch ein guter Wärmeübergang gewährleistet ist. Letzteres ist mit den bekannten Leiterplatten aus Kunststoff nicht gegeben, so dass die Leistungsteile derzeit je nach Applikationsanforderung auf relativ aufwendigen Substraten, beispielsweise DCB(Direct Copper Bonding)-Aluminiumoxid, IMS(Aluminium-Polyimid-Kupfer) oder Aluminiumnitrit aufgebaut werden. Die Logikteile andererseits können ohne weiteres auf der Basis der bekannten Epoxi-Leiterplatten hergestellt werden.

Problematisch bei der herkömmlichen Modultechnik ist die Verbindung zwischen dem Logik- und dem Leistungsteil. Diese Verbindung, bei der typischerweise Lötkontakte, Steckverbindungen oder Druckkontakte eingesetzt werden, ist oftmals eine qualitative Schwachstelle und verursacht hohe Kosten. Noch grösser werden die Probleme mit der Verbindungstechnik, wenn aus Platzgründen vom Anwender ein Sandwich-Aufbau des Moduls angefordert wird, bei dem beispielsweise das Leistungssubstrat über Pins mit dem darüber angeordneten Logikteil verbunden ist, wie beispielsweise aus der EP 0463 589 A2 bekannt. Derartige Logik-Leistungsmodule in Sandwich-Bauweise sind bereits auf dem Markt erhältlich.

Aus der Patentschrift US 4,495,546 ist bereits ein Sandwich-Aufbau bekannt, allerdings nicht Leistungsmodule, sondern zwei Dickschichtschaltungen mit Aluminiumsubstraten betreffend, die beide von einer flexiblen Leiterplatte überdeckt sind, die ausserdem zwischen den beiden Schaltungsteilen einen biegsamen Zwischenabschnitt bildet, der zur Bildung des Sandwich um 180° gebogen wird. Da nicht nur der zu biegende Zwischenabschnitt, sondern die Leiterplatte als ganzes als flexibel vorgesehen ist, wird das als Material für flexible Leiterplatten bekannte Polyimid vorgeschlagen, das jedoch relativ kostenaufwendig ist.

Aus der WO96/13966 ist ein Modul bekannt mit Leistungs- und Logikkomponenten, die auf einem Substrat integriert sind. Die Leistungshalbleiter werden mit Dickdraht mit dem Substrat elektrisch verbunden. Das Substrat wird dann in eine Systemleiterplatte integriert und mittels gelöteter Anschlussstifte mit dieser verbunden. Die Anschlussstifte können die unterschiedliche Wärmeausdehnung von Substrat und Leiterplatte ausgleichen. Nachteilig ist, dass alle Bauteile des Moduls auf dem teuren Leistungssubstrat aufgebaut sind und die Verbindung des Moduls mit der Systemleiterplatte sehr aufwendig ist.

Der Erfindung liegt die Aufgabe zugrunde ein intelligentes Leistungsmodul, insbesondere in Sandwich-Bauweise zu schaffen, das ohne aufwendige Verbindungstechnik auskommt und deshalb einfach herstellbar ist.

Erfiadungsgemäss wird dies erreicht durch ein intelligentes Leistungsmodul mit den Merkmalen des Patentanspruches 1.

Das Leistungsmodul besteht aus einem Leistungsteil, dessen elektronische Bauelemente auf einem Leistungssubstrat aufgebaut sind, und einem Logikteil, dessen Bauelemente auf einer Leiterplatte oder Mehrlagenleiterplatte aufgebaut sind. Die Trennung von Logik- und Leistungsbauelementen hat den Vorteil, dass für den Logikteil eine preisgünstige Leiterplatte verwendet werden kann und nur ein kleines, teures, leistungsfähiges Leistungssubstrat nötig ist.

Die Leiterplatte weist eine Aussparung auf, in der das Leistungsteil angeordnet und mit dem Logikteil elektrisch verbunden ist. Diese Verbindung mittels AL-Dickdraht ist kostengünstig im Nutzen herstellbar.

Das Leistungssubstrat selbst und die das Leistungssubstrat umgebenden Bereiche der Leiterplatte sind auf eine Kühlplatte montiert.

In einem ersten Ausführungsbeispiel bleibt jedoch mindestens ein Streifenbereich entlang einer Seite der Leiterplatte frei. Die Leiterplatte weist an dieser Seite Kontaktpads auf, mittels derer das Modul direkt in die schlitzartige Öffnung einer Systemleiterplatte einlötbar ist. In einem zweiten Ausführungsbeispiel ist die Leiterplatte als Mehrlagenplatte aufgebaut, die einen Laminataufbau aus leitend beschichteten Lagen aufweist, deren Trägerwerkstoff jeweils aus einem Glasfaser-Harzgewebe besteht.

Die Mehrlagenleiterplatte besteht aus zwei Teilen, die durch einen dünnen Zwischenabschnitt verbunden sind, in dem alle unteren Lagen der Mehrlagenleiterplatte nicht vorhanden sind und die bauelementeseitig oberste Lage als flexible elektrische und mechanische Verbindungslage zwischen beiden Teilen biegbar weitergeführt ist.

Vorteilhafte Ausgestaltungen der Erfindung sind in Unteransprüchen gekennzeichnet.

Die Erfindung wird im folgenden anhand eines Ausführungsbeispiels unter Bezugnahme auf die Figuren näher erläutert.
- Figur 1 zeigt: in perspektivischer Draufsicht ein erstes Ausführungsbeispiel eines erfindungsgemässen Moduls im noch nicht in eine Systemleiterplatte eingelöteten Zustand;
- Figur 2 zeigt: in seitlicher Schnittdarstellung das gleiche Modul wie in Figur 1, jedoch im fertigen, eingelöteten Zustand;
- Figur 3 zeigt: in perspektivischer Draufsicht ein zweites Ausführungsbeispiel eines erfindungsgenässen Moduls im noch nicht übereinandergeklappten Zustand;
- Figur 4 zeigt: in seitlicher Schnittdarstellung das gleiche Modul wie in Figur 3, jedoch im fertigen, übereinandergeklappten Zustand.

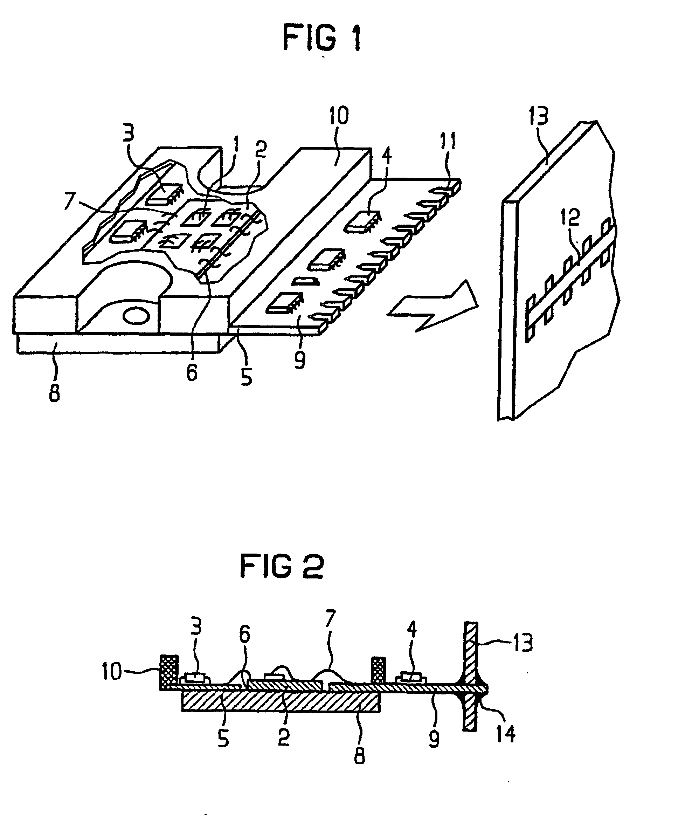

In Figur 1 ist ein beispielsweise für Verlustleistungen ab 20 W geeignetes Modul dargestellt, das prinzipiell aus einem Logikteil und einem Leistungsteil besteht. Die vor allem Leistungshalbleiter umfassenden Bauelemente 1 des Leistungsteils sind auf einem geeigneten (s. oben) Leistungssubstrat 2 angeordnet, insbesondere gebondet. Die Bauelemente 3 und 4 (IC's und andere SMD-Teile) des Logikteils sind auf einer Leiterplatte 5 aus konventiellem Material angeordnet, die eine Aussparung 6 in der Grösse des Leistungsteils aufweist. Das in der Aussparung 6 angeordnete Leistungssubstrat 2 ist über Bonddrähte 7 mit den umgebenden Bereichen der Leiterplatte 5 verbunden. Eine aufwendige verbindungstechnik, beispielsweise mit Kontaktkämmen, wird also an dieser Stelle vermieden. Die zunächst nur durch die einzelnen Aussparungen unterbrochene Leiterplatte kann im Nutzen gebondet werden.

Der überwiegende Teil der Leiterplatte 5 ist zusammen mit dem darin angeordneten Leistungssubstrat 2 auf einer Kühlplatte 8 befestigt, beispielsweise mittels wärmeleitfähigem Kleber oder mittels Löttechnik. Die Oberseite dieses überwiegenden Teils der Leiterplatte 5 kann zum Schutz der Halbleiterbauelemente zum Beispiel mit einer Silikonvergussmasse 10 abgedeckt sein. Der von Vergussmasse 10 bzw. der Kühlplatte 8 freibleibende Streifenbereich 9 muss jedenfalls breit genug sein, um ein Ausbilden von Kontaktpads 11 an der Leiterplatte 5 selbst und ein Durchstecken durch den Öffnungsschlitz 12 einer zweiten Leiterplatte, hier Systemleitezplatte 13 genannt, zu erlauben.

Figur 2 zeigt ein schwallgelötetes Modul mit den Lötstellen 14. Derartige direkt einlötbare Leiterplatten sind zwar seit kurzem bekannt, sie werden jedoch nicht in der Funktionseinheit von Power Modulen eingesetzt die typischerweise robustere konstruktive Elemente verwenden.

Der erfindungsgemässe konstruktive Aufbau minimiert einerseits die erforderliche Verbindungstechnik auf Bonden und direktes Einlöten in die Systemleiterplatte; andererseits resultiert durch den horizontalen Aufbau ein vorteilhaft flaches Modul. Das Modul kann insbesondere mittels seiner Kühlplatte 8 in einem Gehäuse mechanisch arretiert werden.

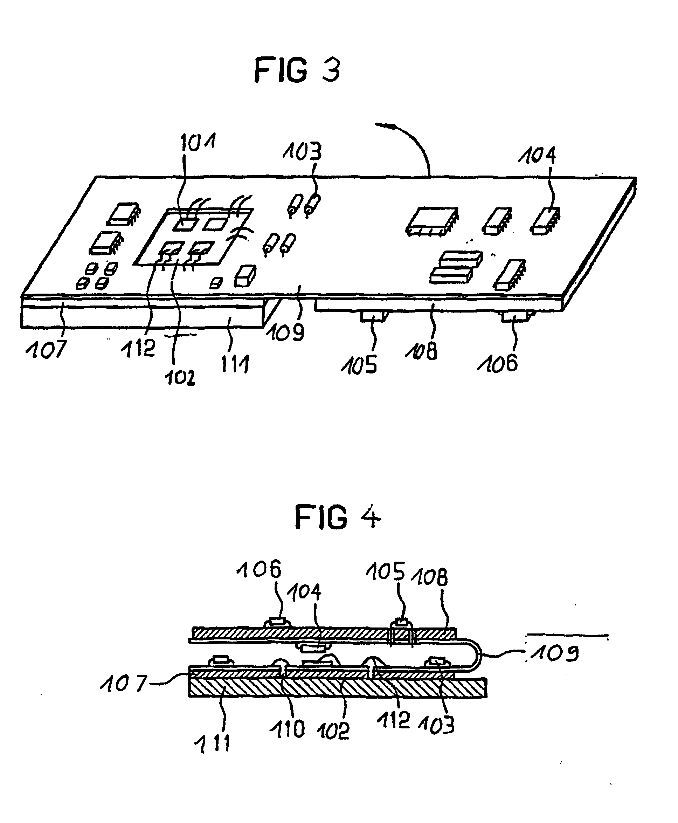

In Figur 3 ist ein beispielsweise für verlustleistungen ab 20 W geeignetes Modul dargestellt, das prinzipiell aus einem Logikteil und einem Leistungsteil besteht. Die Bauelemente 101 des Leistungsteils sind auf einem geeigneten (s. oben) Leistungssubstrat 102 angeordnet. Die Bauelemente 103 bis 106 des Logikteils sind auf einer Mehrlagenleiterplatte angeordnet, die aus zwei Teilen 107 und 108 besteht, und deren erster Teil 107 eine Aussparung 110 in der Grösse des Leistungsteils aufweist. Das in der Aussparung 110 angeordnete Leistungssubstrat 102 ist über Bonddrähte 112 mit den umgebenden Bereichen des ersten Teils 107 der Mehrlagenleiterplatte verbunden. Eine aufwendige Verbindungstechnik. beispielsweise mit Kontaktkämmen, wird also an dieser Stelle vermieden. Die zunächst nur durch die einzelnen Aussparungen unterbrochene Leiterplatte kann im Nutzen gebondet werden.

Durch die mit der Bondtechnik einhergehende Anordnung von Leistungsteil und Teilen des Logikteils in einer Ebene, also nebeneinander, ergibt sich ein erhöhter Platzbedarf, der entschärft werden kann, indem das Logikteil teilweise in eine andere Ebene verlagert wird. Dies ist erfindungsgemäss möglich, ohne wiederum neue aufwendige Verbindungstechnik zur weiteren Ebene zu erfordern.

Die Mehrlagenleiterplatte ist im Zwischenabschnitt bezüglich ihrer Eigenschaft als Träger im wesentlichen unterbrochen, da die beiden Teile 107 und 108 dort nur durch eine dünne Verbindungslage 109 verbunden sind. Dies gewährleistet einerseits eine direkte elektrische Verbindung ohne zusätzliche Verbindungstechnik zwischen den beiden Teilen 107 und 108, während andererseits die mechanische Verbindung zwischen den beiden Teilen 107 und 109 nicht meter starr, sondern flexibel ist. Fertigungstechnisch kann dies beispielsweise dadurch erreicht werden, dass im Nutzen Lükken (für die Zwischenabschnitte) gestanzt werden, so dass die Mehrlagenleiterplattenteile 107 und 108 nur noch an Stegen hängen. Anschliessend wird eine letzte oberste Lage über die beiden Teile 107 und 108 und über die zuvor gestanzte Lücke drüberlaminiert, die dann als flexible Verbindungslage 109 den Zwischenabschnitt bildet. Danach erfolgt das Ausbrechen der einzelnen, zweiteiligen Mehrlagenleiterplatten, das Montieren der Kühlplatten und das Bestücken mit Logikbauelementen bzw. das Einsetzen des Leistungssubstrats in die vorgesehene Aussparung 110.

Als Trägerwerkstoff für die Lagen und damit auch für die oberste Verbindungslage 109 eignet sich beispielsweise konventionelles kupferkaschiertes Glasfaser-Harzgewebe mit der Spezifikation (NEMA Grade) FR4 und FR5. Die ca. 0.3 mm dikke glasfaserartige Verbindungslage 109 ist stabil und flexibel genug, um gebogen zu werden, z.B. um 90 oder 180°.

In Figur 4 ist ein fertiger Sandwich-Aufbau des erfindungsgemässen Moduls dargestellt. Erkennbar sind die übereinander angeordneten, etwa gleich grossen Teile 107 und 108 der Mehrlagenleiterplatte, die mit SMD-Bauteilen 103 bis 105, z.B. IC's oder passive Komponenten, bzw. mit steckmontierten Bauelementen 106 bestückt sind. Das erste Teil 107 der Mehrlagenleiterplatte ist zusammen mit dem darin angeordneten Leistungssubstrat 102 auf einer Kühlplatte 111 befestigt, beispielsweise mittels wärmeleitfähigem Kleber oder mittels Löttechnik. Erkennbar ist auch die Verbindung zwischen Leistungssubstrat 102 und erstem Teil 107 mittels Drahtbondtechnik 112. Durch Weiterführung der bauelementeseitig obersten Lage des Teils 107, also der Verbindungslage 109, können die beiden starren Teile 107 und 108 um das flexible zwischenstück herum geklappt werden.

Das Modul kann insbesondere mittels seiner Kühlplatte 111 in ein Gehäuse eingebaut werden, wobei vorteilhafterweise auch das obere Teil 108 mechanisch am Gehäuse zu arretieren ist. Das obere Teil 108 wird üblicherweise mit Klemmen versehen, die die Netzanschlüsse des Moduls und die Anschlüsse zum angesteuerten Aggregat bilden. Das Modul kann auch zusätzlich mit einer Systemleiterplatte verbunden werden.

## Patentansprüche

1. Intelligentes Leistungsmodul,
mit einem Leistungsteil, dessen elektronische Bauelemente (1) auf einem Leistungssubstrat (2) aufgebaut sind, und einem Logikteil, dessen Bauelemente (3, 4) auf einer Leiterplatte (5) aufgebaut sind, die eine Aussparung (6) aufweist, in der das Leistungsteil angeordnet und mit dem Logikteil mittels Drahtbondtechnik (7) elektrisch verbunden ist,
bei dem das Leistungssubstrat (2) auf einer Kühlplatte (8) montiert ist,
**dadurch gekennzeichnet,**
**daß** die Leiterplatte nur teilweise, nämlich nur mit das Leistungssubstrat (2) umgebenden Bereichen der Leiterplatte auf der Kühlplatte montiert ist.

2. Intelligentes Leistungsmodul nach Anspruch 1,
**dadurch gekennzeichnet,**
**daß** mindestens ein Strelfenbereich (9, 109) entlang einer Seite der Leiterplatte (5) frei bleibt und nicht auf der Kühlplatte montiert ist.

3. Intelligentes Leistungsmodul nach Anspruch 2,
**dadurch gekennzeichnet,**
**daß** die Leiterplatte (5) an der einen Seite Kontaktpads (11) aufweist, mittels derer das Modul direkt in die schlitzartige Öffnung (12) einer Systemleiterplatte (13) einlötbar ist.

4. Intelligentes Leistungsmodul nach Anspruch 1,
**dadurch gekennzeichnet,**
**daß** die Bauelemente (103, 104, 105, 106) des Logikteils auf einer Mehrlagenleiterplatte (107, 108) aufgebaut sind, die eine Aussparung (110) aufweist, in der das Leistungsteil angeordnet und mit dem Logikteil elektrisch verbunden ist, und **dadurch gekennzeichnet, daß** die Mehrlagenleiterplatte (107, 108) einen Laminataufbau aus leitend beschichteten Lagen aufweist, deren Trägerwetkstoff jeweils aus einem Glasfaser-Harzgewebe besteht,
und daß die Mehrlagenleiterplatte aus zwei Tellen (107, 108) besteht, die durch einen dünnen Zwischenabschnitt verbunden sind, in dem alle unteren Lagen der Mehrlagenleiterplatte (107, 108) nicht vorhanden sind und nur die bauelementeseitig oberste Lage als flexible elektrische und mechanische Verbindungslage (109) zwischen beiden Teilen (107, 108) biegbar weitergeführt ist.

5. Intelligentes Leistungsmodul nach Anspruch 4,
**dadurch gekennzeichnet,**
**daß** die flexible Verbindungslage (109) um 180° gebogen ist, so daß die beiden Teile (107,108) biegbar weitergeführt sind.

6. Intelligentes Leistungsmodul nach Anspruch 5,
**dadurch gekennzeichnet,**
**daß** das erste, die Aussparung (110) aufweisende Teil (107) der Mehrlagenlelterplatte und das zweite, hochgeklappte Teil (108) etwa gleich groß sind, daß das erste Teil (107) auf einer Kühlplatte (111) montiert ist, die größer als die Leistungssubstratfläche ist, und daß die elektrischen Verbindungen (112) zwischen dem Leistungssubstrat (102) und dem ersten Teil (107) der Mehrlagenlelterplatte mittels Drahtbendtechnik (112) hergestellt sind.

## Claims

1. An intelligent power module, having a power part, whose electronic components (1) are disposed on a power substrate (2), and a logic part, whose components (3, 4) are disposed on a printed circuit board (5) which comprises a recess (6) in which the power part is arranged and connected electrically with the logic part by the wire bonding method (7), in which the power substrate (2) is mounted on a cooling plate (8),
**characterised in that**
the printed circuit board is mounted only partly, namely only with areas of the printed circuit board which surround the power substrate (2), on the cooling plate.

2. An intelligent power module according to claim 1, **characterised in that** at least one strip area (9, 109) remains free along one side of the printed circuit board (5) and is not mounted on the cooling plate.

3. An intelligent power module according to claim 2, **characterised in that** the printed circuit board (5) comprises contact pads (11) on the one side, by means of which pads the module may be soldered directly into the slot-like opening (12) in a system printed circuit board (13).

4. An intelligent power module according to claim 1, **characterised in that** the components (103, 104, 105, 106) of the logic part are disposed on a multilayer printed circuit board (107, 108) which comprises a recess (110) in which the power part is arranged and connected electrically with the logic part, and **characterised in that** the multilayer printed circuit board (107, 108) comprises a laminate structure consisting of conductively coated layers, the support material of which consists in each case of a resinified glass fibre fabric,
and **in that** the multilayer printed circuit board consists of two parts (107, 108), which are connected by a thin intermediate portion, in which none of the lower layers of the multilayer printed circuit board (107, 108) are present and only the component-side uppermost layer is continued in bendable manner as a flexible electrical and mechanical connecting layer (109) between the two parts (107, 108).

5. An intelligent power module according to claim 4, **characterised in that** the flexible connecting layer (109) is bent by 180°, such that the two parts (107, 108) are continued in bendable manner.

6. An intelligent power module according to claim 5, **characterised in that** the first part (107), comprising the recess (110), of the multilayer printed circuit board and the second, folded-up part (108) are approximately of equal size, **in that** the first part (107) is mounted on a cooling plate (111) which is larger than the power substrate surface, and **in that** the electrical connections (112) between the power substrate (102) and the first part (107) of the multilayer printed circuit board are produced by the wire bonding method (112).

## Revendications

1. Module de puissance intelligent, comprenant une partie de puissance, dont les composants électroniques (1) sont montés sur un substrat de puissance (2), et une partie logique, dont les composants (3, 4) sont montés sur une plaquette de circuits (5), comportant un évidement (6), dans lequel est agencée la partie de puissance, raccordée électriquement à la partie logique par une technique à fils de connexion (7), le substrat de puissance (2) étant monté sur une plaque de refroidissement (8),
**caractérisé en ce que**
la plaquette de circuits n'est montée que partiellement sur la plaque de refroidissement, à savoir seulement avec les zones de la plaquette de circuits entourant le substrat de puissance (2).

2. Module de puissance intelligent selon la revendication 1, **caractérisé en ce qu'**au moins une zone en bande (9, 109) s'étendant le long d'un côté de la plaquette de circuits (5) reste dégagée et n'est pas montée sur la plaque de refroidissement.

3. Module de puissance intelligent selon la revendication 2, **caractérisé en ce que** la plaquette de circuits (5) comporte sur un côté des plots de contact (11) permettant la fixation directe par brasage du module dans l'ouverture en fente (12) d'une plaquette de circuits du système (13).

4. Module de puissance intelligent selon la revendication 1, **caractérisé en ce que** les composants (103, 104, 105, 106) de la partie logique sont montés sur une plaquette de circuits multicouche (107, 108), comportant un évidement (110), dans lequel est agencée la partie de puissance, connectée électriquement à la partie logique, et **caractérisé en ce que** la plaquette de circuits multicouche (107, 108) a une structure stratifiée composée de couches à revêtement conducteur, dont le matériau de support est respectivement composé d'un tissu de résine à fibres de verre,
la plaquette de circuits multicouche étant composée de deux parties (107, 108) reliées par une mince section intermédiaire, exempte de toutes les couches inférieures de la plaquette de circuits multicouche (107, 108), seule la couche supérieure extrême du côté des composants étant étendue de manière flexible sous forme d'une couche de liaison électrique et mécanique flexible (109) entre les deux parties (107, 108).

5. Module de puissance intelligent selon la revendication 4, **caractérisé en ce que** la couche de liaison flexible (109) est pliée de 180°, de sorte à étendre les deux parties (107, 108) de manière flexible.

6. Module de puissance intelligent selon la revendication 5, **caractérisé en ce que** la première partie (107) de la plaquette de circuits multicouche comportant l'évidement (110) et la deuxième partie (108) repliée vers le haut ont à peu près la même taille, la première partie (107) étant montée sur une plaque de refroidissement (111), plus grande que la surface du substrat de puissance, les connexions électriques (112) entre le substrat de puissance (102) et la première partie (107) de la plaquette de circuits multicouche étant établies selon une technique à fils de connexion (112).
